# EUROPEAN PATENT SPECIFICATION

(11) **EP 2 813 540 B1**
(45) Date of publication and mention of the grant of the patent: **15.01.2020**
(21) Application number: 13746422.8
(22) Date of filing: 07.02.2013
(51) Int. Cl.: C08J 7/04, C08J 5/18, C09D 127/12, B32B 27/08, B32B 27/28, H01L 31/049, C09D 127/16, C09D 143/04

(54) **MULTILAYERED FILM AND METHOD FOR MANUFACTURING SAME**
MEHRSCHICHTIGE FOLIE UND VERFAHREN ZUR HERSTELLUNG DAVON
FILM MULTICOUCHE ET PROCÉDÉ POUR SA FABRICATION

(30) Priority: 08.02.2012 KR 20120012932
(43) Date of publication of application: 17.12.2014
(73) Proprietor: LG Chem, Ltd., Seoul 150-721 (KR)
(72) Inventor: KIM, Hyun Cheol, Daejeon 305-707 (KR); KO, Hyun Seong, Seoul 158-822 (KR)
(74) Representative: Goddar, Heinz J.
(86) International application number: PCT/KR2013/001017
(87) International publication number: WO 2013/119069

(56) References cited:
- EP-A1- 2 450 397
- EP-A1- 2 698 399
- JP-A- 2000 091 610
- JP-A- 2000 091 611
- KR-A- 20110 068 602
- KR-A- 20110 123 212
- KR-B1- 101 022 820
- US-A1- 2011 297 314

## Description

### [Technical Field]

The present application relates to a multi-layered film, a method of preparing the same, a subsidiary material for preparing a photovoltaic module, and a photovoltaic module.

### [Background Art]

In recent years, much attention has been paid to renewable and clean energy because of global environment problems and exhaustion of fossil fuels. Among these, solar energy has attracted attention as a representative pollution-free energy source which can resolve problems of environmental pollution and exhaustion of the fossil fuels.

A photovoltaic cell to which a principle of solar photovoltaic power generation is applied is a device configured to convert solar light into electric energy. Since the photovoltaic cell is necessarily exposed to external environments for a long period of time to facilitate absorption of the solar light, the photovoltaic cell is prepared in the form of a unit by performing various packaging processes to protect the photovoltaic cell. Such a unit is referred to as a photovoltaic module.

In the photovoltaic module, a backsheet having excellent weather resistance and durability should be used to stably protect the photovoltaic cell even when exposed to external environments for a long period of time. The backsheet for photovoltaic cells comes in contact with ethylene vinyl acetate (EVA) used as a photovoltaic encapsulant so as to physically protect the photovoltaic cell, prevent penetration of moisture into the photovoltaic cell and maintain electrical insulation from the photovoltaic cell. As a result, the backsheet for photovoltaic cells serves to drive the photovoltaic module for 25 years or more without degrading output characteristics. Therefore, the backsheet for photovoltaic cells should have excellent UV resistance and weather resistance, and exhibit excellent long-term reliability including less degradation of mechanical characteristics, moisture barrier properties, and electric insulating properties during use.

To satisfy the above-described characteristics, a product manufactured in a triple-layered structure in which a poly(vinyl fluoride) (PVF) film is stacked on both surfaces of a poly(ethylene terephthalate) (PET) film has been widely used. In the case of the prior art, however, a manufacturing method is complicated, and may be vulnerable to moisture, which may have an influence on long-term reliability of the photovoltaic cell.

Also, backsheets for photovoltaic cells manufactured by processing another fluoropolymer such as poly(vinylidene fluoride) (PVDF), chlorotrifluoroethylene (CTFE) or ethylene chlorotrifluoroethylene (ECTFE) in the form of a film instead of the PVF film have been increasingly used, but the fluoropolymer still has a problem of poor adhesive strength.

For these reasons, there are continuous demands for a backsheet for a photovoltaic cell which has excellent moisture barrier properties, can exhibit excellent durability and weather resistance while maintaining an adhesive strength for a long period of time, reduce the manufacturing cost due to its simple manufacturing method, and improve productivity and qualities of a photovoltaic module.

US20110297314 discloses a method for preparing a multi-layered film laminate having a first layer comprising a perfluorinated copolymer resin layer adhered to a second layer comprising an olefin ester copolymer that has been blended with an organosilan. The multilayered laminate is useful in photovoltaic modules.

### [Disclosure]

### [Technical Problem]

The present application is directed to providing a multi-layered film, a method of preparing the same, a backsheet for photovoltaic cells, and a photovoltaic module.

### [Technical Solution]

One aspect of the present application provides a multi-layered film comprising:a barrier film;a primer layer formed on the barrier film; and a fluoropolymer coating layer formed on the primer layer,wherein the primer layer includes a copolymer having compatibility with a fluoropolymer, and the copolymer having compatibility with the fluoropolymer includes a functional group formed by copolymerization with a silane coupling agent, a titanium-based coupling agent, a zirconium-based coupling agent, or an aluminum-based coupling agent,wherein the copolymer of the primer layer is a copolymer of polymerizable monomer having compatibility with the fluoropolymer; and a silane coupling agent, a titanium-based coupling agent, a zirconium-based coupling agent, or an aluminum-based coupling agent,wherein a mixing ratio of the polymerizable monomer and the coupling agent is 40:60 to 90:10, based on the weight,wherein the primer layer is a coating layer of the copolymer having compatibility with the fluoropolymer, and wherein a Si-O, Ti-O, Zr-O or Al-0 bond is formed at an interface of the barrier film and the primer layer.

Another aspect of the present application provides a method of preparing a multi-layered film. Here, the method includes forming a primer layer by coating an upper portion of a barrier film with a primer coating solution including a copolymer having compatibility with a fluoropolymer; and coating an upper portion of the primer layer with a composition for coating a fluoropolymer,wherein the copolymer having compatibility with the fluoropolymer of the primer coating solution includes a functional group formed by copolymerization with a silane coupling agent, a titanium-based coupling agent, a zirconium-based coupling agent, or an aluminum-based coupling agent,wherein the copolymer of the primer coating solution is a copolymer of polymerizable monomer having compatibility with the fluoropolymer; and a silane coupling agent, a titanium-based coupling agent, a zirconium-based coupling agent, or an aluminum-based coupling agent,wherein a mixing ratio of the polymerizable monomer and the coupling agent is 40:60 to 90:10, based on the weight, and wherein a Si-O, Ti-O, Zr-O or Al-0 bond is formed at an interface of the barrier film and the primer layer.

Further aspects of the invention are set out in the dependent claims.

The multi-layered film of the present application may be, for example, used as a subsidiary material for preparing various photovoltaic modules

### [Advantageous Effects]

According to the present application, the multi-layered film having excellent moisture resistance and weather resistance and simultaneously exhibiting excellent adhesive strength can be provided. Here, the multi-layered film of the present application can ensure adhesive strength since the multi-layered film includes a barrier film having excellent moisture resistance, such as a metal thin film or an inorganic deposition film, a fluoropolymer layer having excellent weather resistance formed on the barrier film by coating, and a primer layer formed between the barrier film and the fluoropolymer layer and including a compatible copolymer modified with a coupling agent. Also, the multi-layered film can be prepared at a low drying temperature with low cost using a low-boiling-point solvent, productivity of the multi-layered film can be increased, and degradation of product qualities caused by thermal deformation or thermal shock can be prevented. As described above, the multi-layered film of the present application can be, for example, effectively used as the backsheet for photovoltaic cells, and thus a photovoltaic module having excellent durability can be provided even when exposed to external environments for a long period of time.

### [Description of Drawings]

FIG. 1 is a cross-sectional view showing a multi-layered film according to one exemplary embodiment of the present application;
FIG. 2 is a diagram showing a surface of a multi-layered film used in Example 1 of the present application before and after a pressure cooker test (PCT); and
FIG. 3 is a diagram showing a surface of a multi-layered film used in Comparative Example 2 of the present application before and after the PCT.

### [Modes of Invention]

Hereinafter, exemplary embodiments of the present application will be described in detail. However, the present application is not limited to the embodiments disclosed below, but can be implemented in various forms. The following embodiments are described in order to enable those of ordinary skill in the art to embody and practice the present application.
With reference to the appended drawings, exemplary embodiments of the present application will be described in detail below. To aid in understanding the present application, like numbers refer to like elements throughout the description of the figures, and the description of the same elements will be not reiterated.

A multi-layered film according to one exemplary embodiment of the present application includes a barrier film, a primer layer formed on the barrier film, and a fluoropolymer coating layer formed on the primer layer.

The primer layer includes a copolymer having compatibility with a fluoropolymer, and the copolymer having compatibility with the fluoropolymer contains a functional group formed by copolymerization with a silane coupling agent, a titanium-based coupling agent, a zirconium-based coupling agent, or an aluminum-based coupling agent, and thus may enhance a bonding force between the barrier film and the fluoropolymer coating layer which are formed above and below the copolymer.

The barrier film is a film having moisture barrier properties. Examples of the barrier film may include a metal thin film, or an inorganic deposition film. More particularly, aluminum foil, copper foil or stainless foil may be used as the metal thin film, and indium tin oxide (ITO), indium zinc oxide (IZO), silicon oxide (SiOₓ) or aluminum oxide (AlOₓ) may be used as the inorganic deposition film. In one exemplary embodiment of the present application, a deposition film including an inorganic deposition layer formed of the above-described material on a substrate PET may be used as the inorganic deposition film. Such a barrier film contains a hydroxyl group bound to a surface thereof.

The barrier film has excellent moisture barrier properties, but is poor in corrosion resistance and weather resistance when exposed to external climates. Accordingly, a surface of the barrier film has to be protected with a weather-resistant resin, for example, a fluoropolymer layer, for use as a subsidiary material for preparing a photovoltaic module, that is, a backsheet for photovoltaic cells. To protect the surface of the barrier film such as a metal with the fluoropolymer layer, a method of attaching a fluoropolymer film to a barrier film, or a method of coating a barrier film with a fluoropolymer may be used.

The former (i.e. the method of attaching a fluoropolymer film to a barrier film) is a method of preparing a film by extruding and casting a fluoropolymer and attaching the fluoropolymer film to a barrier film using an adhesive. However, since this method requires expensive devices for manufacturing a film and uses an adhesive. Also, since the adhesive is used, the method has problems in that coating and lamination processes of the adhesive are required. Further, the unnecessary loss may be caused by use of a film having a higher thickness than a fluoropolymer layer actually required during the processes to handle the film, addition of various additives such as a filler to the fluoropolymer layer is hampered by a variety of restrictions, and a high processing temperature is required.

The latter (i.e. the method of coating a barrier film with a fluoropolymer) uses a fluoropolymer paint to coat a surface of the barrier film such as a metal thin film or an inorganic deposition film. Here, a conventional fluoropolymer paint is obtained by coating an epoxy primer, followed by coating a fluoropolymer. In this case, the method has a problem in that a processing temperature in each process should be equal to or higher than 230 °C, and a baking process should be equal to or higher than 300 °C. Also, the epoxy primer exhibits a low adhesive strength to the fluoropolymer since the epoxy primer has low compatibility with the fluoropolymer unlike a modified acrylic primer such as a silane according to exemplary embodiments of the present application. The primer according to one exemplary embodiment of the present application is a copolymer having compatibility with the fluoropolymer. In this case, since the primer contains a functional group formed by copolymerization with a silane coupling agent, a titanium-based coupling agent, a zirconium-based coupling agent or an aluminum-based coupling agent, the primer may hydrophobically modify a surface of the barrier film having a hydrophilic hydroxyl group. Accordingly, superior corrosion resistance against moisture is exhibited since the interface between the primer and the barrier film is excellent in water resistance. Also, according to formation of a hydrophobic primer layer containing such a certain functional group, the primer serves to connect the hydrophilic barrier film with a fluoropolymer coating solution.

The present inventors introduced a primer layer including a certain copolymer so that a fluoropolymer coating layer can have a high interfacial adhesive strength to a barrier film using a low-temperature process performed at a low temperature of 200 °C or less, unlike the prior art. The copolymer of the primer layer that may be used in exemplary embodiments of the present application has compatibility with a fluoropolymer formed on the copolymer, and also provides a modified copolymer by forming a functional group by copolymerization with a silane coupling agent, a titanium-based coupling agent, a zirconium-based coupling agent, an aluminum-based coupling agent. As a result, the copolymer of the primer layer may serve to improve an interfacial adhesive strength since the functional group, for example, a silanol group, forms a covalent bond or a hydrogen bond with a hydroxyl group present on the surface of the barrier film surface.

That is, an adhesive strength between the barrier film and the fluoropolymer coating layer may be ensured by coating a surface of the barrier film with such a primer and then coating an upper surface of the primer layer with a fluoropolymer, and a weather-resistant fluoropolymer layer may be applied to the barrier film using a simple coating process.

According to the exemplary embodiments of the present application, a covalent bond between silane, organic titanium, organic zirconium or organic aluminum and the hydroxyl group present on the surface of the barrier film is formed at the interface between the barrier film and the primer layer, so that the adhesive strength may be ensured. A hydroxyl group is present on a surface of the barrier film such as a metal thin film or an inorganic deposition film. Such a hydroxyl group forms Si-O Ti-O, Zr-O and Al-O covalent bonds with a silane compound, organic titanium, organic zirconium, and organic aluminum, respectively, and also forms a hydrogen bond with a hydrogen atom of the silane compound, organic titanium, organic zirconium or organic aluminum to improve adhesive strength between the barrier film and the primer layer.

Also, the primer layer composed of the modified copolymer containing a functional group formed by copolymerization with the silane coupling agent, the titanium-based coupling agent, the zirconium-based coupling agent or the aluminum-based coupling agent includes a copolymer having excellent compatibility with the fluoropolymer, for example, an acrylic copolymer, unlike the primer composed of the silane coupling agent, the titanium-based coupling agent, the zirconium-based coupling agent, or the aluminum-based coupling agent alone. As a result, when an upper surface of the primer layer is coated with the fluoropolymer, interdiffusion of components between the compatible copolymer and the fluoropolymer coating layer take place to ensure additional adhesive strength between the layers. This is achieved by means of adhesion according to the interdiffusion of the components between the two layers. By using the feature in which materials of the two layers are brought into contact with each other and the two layers are adhered to each other as the interface between the two layers disappears due to interdiffusion of molecular chains, a multi-layered film having excellent adhesive strength may be prepared by interdiffusion between a single fluoropolymer coating layer and a compatible copolymer of a primer coating layer formed under the single fluoropolymer coating layer.

Therefore, by using a copolymer that contains a functional group formed by copolymerization with a silane coupling agent, a titanium-based coupling agent, a zirconium-based coupling agent or an aluminum-based coupling agent as a primer with respect to the barrier film, and has compatibility with the fluoropolymer, the barrier film may be coated with the fluoropolymer using a simple coating process performed at a low temperature without forming a separate fluoropolymer film.

As the barrier film, the metal thin film has a thickness of approximately 1 to 200 µm, 10 to 100 µm, or 15 to 50 µm. When the barrier film is the inorganic deposition film, the barrier film may have a thickness of approximately 1 to 1,000 nm, for example, 10 to 500 nm, or 50 to 300 nm. However, the thickness of the barrier film is not limited to the above-described thickness range in the present application, but may be properly adjusted as necessary.

To further improve adhesive strength before application of a primer, a surface of the barrier film may be subjected to high-frequency spark discharge treatment such as corona or plasma treatment; thermal treatment; flame treatment; treatment with a coupling agent; treatment with an anchoring agent; or chemical activation treatment using a gas-phase Lewis acid (for example, BF₃), sulfuric acid, or high-temperature sodium hydroxide.

Also, the barrier film may further include a substrate formed thereunder. The specific kind of substrates that may be used in exemplary embodiments of the present application is not particularly limited, and various materials known in the related art may be used, and selected according to functions and uses to be required.

According to one exemplary embodiment of the present application, the substrate may be one of various metals or polymer sheets. As such, examples of the metal may include aluminum, iron, etc., and examples of the polymer sheet may include a polyester-based sheet, a polyamide-base sheet, or a polyimide-based sheet. Among these, a polyester-based sheet is generally used, but the present application is not limited thereto. Examples of the polyester-based sheet may include a single sheet, a stacked sheet or a co-extruded product of poly(ethylene terephthalate) (PET), polyethylene naphthalate (PEN), or polybutylene terephthalate (PBT), but the present application is not limited thereto. Also, a polyester-based sheet having enhanced hydrolysis-resistant characteristics may be used as necessary.

The substrate may have a thickness of approximately 50 to 500 µm, or 100 to 300 µm. Excellent electric insulating properties, moisture barrier properties, mechanical properties and handling properties of the multi-layered film may be maintained by adjusting the thickness of the substrate within the above-described thickness range. In the present application, however, the thickness of the substrate is not limited to the above-described thickness range, but may be properly adjusted as necessary.

In the present application, the substrate may also be subjected to spark discharge treatment, thermal treatment, flame treatment, treatment with a coupling agent, treatment with an anchoring agent, or chemical activation treatment so as to improve an adhesive strength.

A method of stacking the barrier film on the substrate may include lamination using an adhesive layer, lamination using heat and pressure, etc., but the present application is not limited thereto.

The multi-layered film according to one exemplary embodiment of the present application includes a primer layer formed between the substrate and the fluoropolymer coating layer. According to one exemplary embodiment of the present application, the copolymer included in the primer layer of the multi-layered film has compatibility with a fluoropolymer, and ensures adhesive strength between the substrate and the fluoropolymer coating layer.

The copolymer having compatibility with the fluoropolymer includes a main chain backbone having compatibility with the fluoropolymer, and a functional group formed by copolymerizing a silane coupling agent, a titanium-based coupling agent, a zirconium-based coupling agent or an aluminum-based coupling agent into the main chain backbone.

In the present application, the phrase "B having compatibility with A" refers to a physical property in which B is easily mixed or interdiffused with A.

In the present application, the main chain backbone of the copolymer included in the primer layer is not particularly limited as long as it exhibits the physical properties as described above. For example, the main chain backbone of the copolymer may be a least one selected from the group consisting of a (meth)acrylic main chain backbone, a (meth)acrylamide-based main chain backbone, and a main chain backbone of a free radical addition polymer derived from a monomer mixture including a (meth)acrylic monomer, a (meth)acrylamide-based monomer or a vinyl-based monomer as a main component, but the present application is not limited thereto.

The primer layer has such compatibility that an adhesive strength between the above-described barrier film and a fluoropolymer included in the fluoropolymer coating layer as will be described later can be sufficiently exhibited. In this case, as both of the layers are formed by a coating method, the interface between the two layers disappears due to interdiffusion of molecular chains therebetween. That is, during formation of the multi-layered film, interdiffusion between the primer and the fluoropolymer included in the fluoropolymer coating layer take place at the interface between the primer layer and the fluoropolymer coating layer. Accordingly, it can be expected that physical interactions by chain entanglement and a van der Waals' force is generated between molecular chains of components of the fluoropolymer coating layer and the primer layer, thereby enhancing the adhesive strength. As a result, the two layers can be adhered without a separate adhesive, and the prior-art problem of durability generated by an interface adhesive may be resolved. Also, the van der Waals' force may be further enhanced by a dipole-dipole interaction.

Also, the copolymer of the primer layer further contains a functional group formed by copolymerizing a silane coupling agent, a titanium-based coupling agent, a zirconium-based coupling agent, or an aluminum-based coupling agent. Such a functional group may be introduced to an inside of a main chain, side chain or end of the polymer. Hereinafter, the copolymer containing a functional group formed by copolymerizing the silane coupling agent, the titanium-based coupling agent, the zirconium-based coupling agent or the aluminum-based coupling agent is referred to as a modified copolymer.

Such a copolymer may be a copolymer of a polymerizable monomer having compatibility with a fluoropolymer; a silane coupling agent, a titanium-based coupling agent, a zirconium-based coupling agent, or an aluminum-based coupling agent. In this case, a compound having a double bond for radical copolymerization may be used as the silane coupling agent, the titanium-based coupling agent, the zirconium-based coupling agent or the aluminum-based coupling agent used herein.

The polymerizable monomer having compatibility with the fluoropolymer may be at least one selected from the group consisting of a (meth)acrylic monomer, a (meth)acrylamide-based monomer, and a vinyl-based monomer.

Examples of the (meth)acrylic monomer may include, but are not limited to, at least one selected from the group consisting of methyl(meth)acrylate, ethyl(meth)acrylate, propyl(meth)acrylate, n-butyl(meth)acrylate, s-butyl(meth)acrylate, t-butyl(meth)acrylate, isobutyl(meth)acrylate, hexyl(meth)acrylate, 2-ethylhexyl(meth)acrylate, n-octyl(meth)acrylate, isooctyl(meth)acrylate, n-nonyl(meth)acrylate, isononyl(meth)acrylate, n-decyl(meth)acrylate, isodecyl(meth)acrylate, n-dodecyl(meth)acrylate, n-tridecyl(meth)acrylate, n-tetradecyl(meth)acrylate, glycidyl(meth)acrylate, glycidyl alkyl(meth)acrylate, and isocyanato alkyl(meth)acrylate, which may be used alone or in combination.

Examples of the (meth)acrylamide-based monomer that may be used herein may include at least one selected from the group consisting of acrylamide, methacrylamide, bisacrylamide, hydroxy acrylamide, diacetone acrylamide, isobutoxymethyl acrylamide, butoxymethyl acrylamide, methoxypropyl acrylamide, and ethylenebisacrylamide, but the present application is not limited thereto.

A specific example of the silane coupling agent having a double bond may be a vinyl alkoxy silane. For example, the silane coupling agent may be vinyltrimethoxysilane (CH₂=CH₂Si(OCH₃)₃), vinyltriethoxysilane (CH₂=CH₂Si(OC₂H₅)₃), vinyltripropoxysilane, vinyltriisopropoxysilane, vinyltributoxysilane, vinyltripentoxysilane, vinyltriphenoxysilane, vinyltriacetoxysilane (CH₂=CH₂Si(OCOCH₃)₃), methacryloxysilane, methacryloxypropyl trimethoxysilane, methacryloxypropyl triethoxysilane, N-(3-methacryloxy hydroxypropyl)-3-aminopropyltriethoxysilane, methacryloyloxypropyl tristrimethylsilyloxysilane, vinyl tris(2-methoxyethoxy)silane, and tri(isopropoxy)vinylsilane or a mixture thereof.

The titanium-based coupling agent having a double bond may be at least one selected from the group consisting of isopropyl trimethacryl titanate, isopropyl triacryloyl titanate, isopropyl trioleyl titanate, titanium IV 2,2-(bis-2-propenolatomethyl)butanolato,tris(dioctyl)pyrophosphate-O, titanium, (isooctadecanolato-KO)bis(2-methyl-2-propenolato-KO)(2-propenolato), titanium IV 2,2-(bis-2-propenolatomethyl)butanolato,tetra(2,2-diallyloxymethyl-1-butoxytitanium di(ditridecyl)phosphate, neopentyl diallyloxy tris-neodecanoyl-titanate, neopentyl (diallyl)oxy,tri(dioctyl)phosphato titanate, neopentyl diallyloxy tris(N-ethylenediamino)ethyl titanate, isopropyl triethanolamine titanate, ethoxy iso-propoxy titanium acetylacetonate, diisopropoxydi(ethoxyacetoacetyl) titanate, and diisobutoxy-bis ethylacetoacetato titanate.

The zirconium-based coupling agent having a double bond may be at least one selected from the group consisting of zirconium IV tetrakis-2,2-(bis-2-propenolatomethyl)butanolato, zirconium IV 2,2-dimethyl 1,3-propanediolato,bis(dioctyl)pyrophosphate-O, zirconium IV 1,1-(bis-2-propenolatomethyl)butanolato,tris(2-amino)phenylato-O, and zirconium IV 2,2-(bis-2-propenolatomethyl)butanolato,bis(3-mercapto)propionato-O.

The aluminum-based coupling agent having a double bond may be at least one selected from the group consisting of aluminum III diisopropoxide-ethylacetoacetate, and aluminum 2,4-pentane dionate.

Upon preparation of the modified copolymer included in the primer layer according to the exemplary embodiments of the present application, the mixing ratio of the polymerizable monomer and the coupling agent is 40:60 to 90:10, based on the weight. As described above, the contents of the polymerizable monomer and the coupling agent may be adjusted to control interdiffusion with the fluoropolymer coating layer and an increase in a bonding force to a surface of the barrier film formed under the copolymer.

When only a silane coupling agent, a titanium-based coupling agent, a zirconium-based coupling agent or an aluminum-based coupling agent may be used as the primer, the coupling agent that is a monomer or a small molecule has poor coatability (wettability) with respect to a metal or inorganic deposition film, and monomers which do not participate in a binding reaction after coating degrade physical properties of a coating film. That is, when only the silane coupling agent, the titanium-based coupling agent, the zirconium-based coupling agent or the aluminum-based coupling agent is used as the primer, a primer film is not compactly formed since the coupling agent has a small molecular weight. As a result, it may be difficult to form a film having a uniform thickness since moisture penetrates into the primer film with time. In this case, an adhesive strength may also be lowered due to insufficient interdiffusion with the fluoropolymer. Therefore, a modified copolymer obtained by copolymerizing a coupling agent into a compatible copolymer, for example, a silane-modified acrylic copolymer, may be used herein. Such a modified copolymer may be favorable in aspects of a reaction time and a reaction mechanism since sites at which a binding reaction takes place at the interface between the substrate and the fluoropolymer coating layer increase in number compared to the compatible copolymer which does not contain a functional group formed by copolymerization of a coupling agent. Accordingly, it is possible to achieve desired physical properties.

For example, the above-described modified copolymer may provide a silyl group represented by the following Formula 1, and may be prepared by copolymerizing a silane coupling agent having a double bond, or grafting the silane coupling agent into a compatible copolymer.

Formula 1 -Si(OR)₃

In Formula 1, R may be the same as or different from each other, and represents hydrogen, an alkyl group, an aryl group, an aralkyl group, or an alkoxy group.

As such, the alkyl group may be, for example, an alkyl group having 1 to 12 carbon atoms, 1 to 8 carbon atoms, or 1 to 4 carbon atoms. Also, the aryl group may be an aryl group having 6 to 18 carbon atoms, or 6 to 12 carbon atoms, for example, a phenyl group. Also, the aralkyl group may be an aralkyl group having 7 to 19 carbon atoms, or 7 to 13 carbon atoms, for example, a benzyl group. And the alkoxy group may be an alkoxy group having 1 to 12 carbon atoms, 1 to 8 carbon atoms, or 1 to 4 carbon atoms.

That is, according to one exemplary embodiment of the present application, the modified copolymer may be a silane-modified acrylic copolymer. Also, the modified copolymer may be a copolymer including an acrylic monomer and a silane coupling agent represented by the following Formula 2 in a copolymerized form, or a grafted polymer obtained by grafting the silane coupling agent represented by the following Formula 2 into an acrylic copolymer.

Formula 2 DSi (OR)₃

In Formula 2, D is an ethylenic unsaturated hydrocarbon group or a hydrocarbon oxy group, and R is as described in Formula 1.

According to the exemplary embodiments of the present application, D in Formula 2 may be vinyl, allyl, isopropenyl, butenyl, cyclohexenyl, or γ-methacryloxypropyl, preferably, vinyl.

To prepare the modified copolymer, a radical initiator may be further added to the polymerizable monomer and the coupling agent. Here, the radical initiator may serve to initiate copolymerization by inducing radical polymerization of a vinyl group of each monomer.

The specific kind of radical initiators that may be used in the present application is not particularly limited as long as they can initiate radical polymerization. For example, the radical initiator may include an organic peroxide, hydroperoxide, or azo compound, which may be used alone or in combination.

As such, examples of the radical initiator may include at least one selected from the group consisting of a dialkyl peroxide such as t-butylcumylperoxide, di-t-butyl peroxide, di-cumyl peroxide, 2,5-dimethyl-2,5-di(t-butylperoxy)hexane, or 2,5-dimethyl-2,5-di(t-butylperoxy)-3-hexine, a hydroperoxide such as cumene hydroperoxide, diisopropyl benzene hydroperoxide, 2,5-dimethyl-2,5-di(hydro peroxy)hexane, or t-butyl hydroperoxide, a diacyl peroxide such as bis-3,5,5-trimethylhexanoyl peroxide, oxtanoylperoxide, benzoyl peroxide, o-methylbenzoylperoxide, or 2,4-dichlorobenzoyl peroxide, a peroxyester such as t-butylperoxy isobutyrate, t-butylperoxy acetate, t-butylperoxy-2-ethylhexanoate, t-butylperoxy pivalate, t-butylperoxy octoate, t-butylperoxyisopropyl carbonate, t-butylperoxybenzoate, di-t-butylperoxyphthalate, 2,5-dimethyl-2,5-di(benzoylperoxy)hexane, or 2,5-dimethyl-2,5-di(benzoylperoxy)-3-hexine, a ketone peroxide such as ethylethylketone peroxide, or cyclohexanone peroxide, and an azo compound such as lauryl peroxide, azobisisobutyronitrile, or azobis(2,4-dimethylvaleronitrile).

The radical initiator may be included at a content of 0.1 to 5 parts by weight, or 0.5 to 2 parts by weight, based on 100 parts by weight of solid contents of the polymerizable monomer and the coupling agent. Within this content range, overall physical properties of a resin composition may be effectively adjusted to enhance an adhesive property to the barrier film and maintain excellent activities of an additive such as a UV stabilizer included in the resin composition.

When the silane-modified acrylic copolymer is prepared as the primer as described above, a silyl group may be included as the functional group. However, the silyl group may be converted into a silanol group during coating and drying of a primer layer, and bound to a hydroxyl group present on a surface of the barrier film (i.e., a metal). Also, the silanol group may be included from the beginning of preparation of a primer. This is because the silyl group is easily converted into the silanol group under a certain condition such as heat or humidity. Also, after preparation of a primer material, a method of converting a silyl group into a silanol group may be further performed, and primer coating may then be performed.

The primer layer including the modified copolymer may be formed on the barrier film using a coating method capable of forming a primer layer having a thickness greater than a predetermined thickness, such as bar coating, spray coating, gravure coating, etc.

The thickness of the primer layer may be in a range of approximately 0.01 to 5 µm, for example, 0.05 to 3 µm, or 0.1 to 2 µm. The thickness of the primer layer may be adjusted by controlling a solid content thereof. When the thickness of the primer layer is adjusted within this thickness range, an adhesive strength may be improved by widening an interdiffusion area between the fluoropolymer coating layer and the primer layer. When the thickness of the primer layer exceeds a predetermined thickness, the primer layer may be easily broken. As a result, adhesive strength may be degraded, and physical properties of the fluoropolymer coating layer may be easily changed. Therefore, it is desirable to form the primer layer within this thickness range.

The multi-layered film of the present application includes a fluoropolymer coating layer formed on the primer layer. The coating layer means that a fluoropolymer coating layer including a fluoropolymer is prepared by a method of coating a substrate or a primer layer with a coating solution prepared by dissolving a fluoropolymer in a solvent, for example, a solvent having a low boiling point, rather than a method of laminating a sheet prepared by a casting or extrusion method on a substrate using an adhesive.

When a layer including the fluoropolymer is formed by coating as described above, an interdiffusion action with the primer layer may be effectively carried out to maximize an effect of improving an adhesive strength. Also, a solvent having a low boiling point may be used during formation of the fluoropolymer coating layer. As a result, a drying process may be performed at a low temperature, thereby improving productivity of a product and ensuring excellent product qualities.

The specific kind of fluoropolymers that may be used according to the exemplary embodiments of the present application is not particularly limited. For example, the fluoropolymer may be a monopolymer, a copolymer or a mixture thereof including at least one monomer selected from the group consisting of vinylidene fluoride (VDF), vinyl fluoride (VF), tetrafluoroethylene (TFE) hexafluoropropylene (HFP), chlorotrifluoroethylene (CTFE), trifluoroethylene, hexafluoroisobutylene, perfluoro butylethylene, perfluoro(methylvinylether) (PMVE), perfluoro(ethylvinylether) (PEVE), perfluoro(propylvinylether) (PPVE), perfluoro(hexylvinylether) (PHVE), perfluoro-2,2-dimethyl-1,3-dioxol (PDD) and perfluoro-2-methylene-4-methyl-1,3-dioxolane (PMD) in a polymerized form.

According to the present application, the fluoropolymer may be, for example, a monopolymer or copolymer including vinyl fluoride in a polymerized form, a monopolymer or copolymer including vinylidene fluoride in a polymerized form, or a mixture including at least two of the monopolymers or copolymers.

As such, the kind of comonomers that may be included in the copolymer in a polymerized form is not particularly limited. For example, the comonomer may include, but is not limited to, hexafluoropropylene (HFP), chlorotrifluoroethylene (CTFE), tetrafluoroethylene (TFE), trifluoroethylene, hexafluoroisobutylene, perfluorobutylethylene, perfluoromethylvinylether (PMVE), perfluoro-2,2-dimethyl-1,3-dioxol (PDD), and perfluoro-2-methylene-4-methyl-1,3-dioxolane (PMD), which may be used alone or in combination. Also, the comonomer in the copolymer may be, for example, included at a content of approximately 0.5 to 50% by weight, 1 to 40% by weight, 7 to 40% by weight, 10 to 30% by weight, or 10 to 20% by weight, based on the total weight of the copolymer. Within this content range of the comonomer, an interdiffusion action and low-temperature drying may be effectively induced while ensuring durability and weather resistance of the multi-layered film.

The fluoropolymer may be a linear or branched polymer in an aspect of morphology.

According to one exemplary embodiment of the present application, the fluoropolymer may have a weight average molecular weight of 50,000 to 1,000,000. In the present application, the weight average molecular weight is a value converted from that of a polystyrene standard as measured using gel permeation chromatography (GPC). According to the present application, when the weight average molecular weight of the resin is adjusted within this molecular weight range, excellent solubility and other physical properties may be ensured.

In the present application, the fluoropolymer may also have a melting point of 80 to 175 °C, or 120 to 165 °C. According to the present application, when the melting point of the resin is adjusted to a temperature of 80 °C or more, deformation of the multi-layered film caused during use thereof may be prevented. Also, when the melting point of the resin is adjusted to a temperature of 175 °C or less, solubility in a solvent may be adjusted, and gloss of a coated surface may be improved.

The fluoropolymer coating layer according to one exemplary embodiment of the present application may further include an amorphous resin together with the above-described fluoropolymer as necessary. As described above, a blend with the amorphous resin may be used to maximize processability including interaction with the above-described primer layer, and solubility in a low-boiling-point solvent. In the present application, the term "amorphous resin" includes a resin whose entire structure is not crystalline, as well as a resin in which a crystalline region is partially present but an amorphous region is dominant over the crystalline region.

The kind of amorphous resins that may be used in the present application is not particularly limited. For example, the amorphous resin may include, but is not limited to, an acrylic resin, a polycarbonate, a polyvinyl chloride, a styrene-(meth)acrylonitrile copolymer, a styrene-maleic anhydride copolymer, a cycloolefin polymer, a polyacrylonitrile, a polystyrene, a polysulfone, a polyethersulfone, or a polyarylate, which may be used alone or in combination. Among these, a non-reactive acrylic resin may be used, but the present application is not limited thereto.

As such, examples of the acrylic resin may include a monopolymer or a copolymer including methyl (meth)acrylate, ethyl (meth)acrylate, propyl (meth)acrylate, butyl (meth)acrylate, (meth)acrylic acid, isobornyl (meth)acrylate, and a combination thereof. Also, an acrylic resin including one or two or more monomers selected from the above-described components, and at least one comonomer selected from cyclohexyl maleimide, methyl styrene and (meth)acrylonitrile in a polymerized form may also be used to control a glass transition temperature and a molecular weight distribution as necessary.

In the present application, when the amorphous resin is in the form of a copolymer including two or more monomers in a polymerized form, the kind and content of the comonomer are not particularly limited, and may be adjusted in consideration of desired amorphous properties.

In the present application, when the fluoropolymer coating layer includes an amorphous resin, the fluoropolymer coating layer may include a fluorine-based resin at a content of 50 parts by weight or more, and an amorphous resin at a content of 50 parts by weight or less. More particularly, the fluoropolymer coating layer may include the fluorine-based resin at a content of 70 to 97 parts by weight, and the amorphous resin at a content of 3 to 30 parts by weight. As the resins are controlled within this content range, the components constituting the fluoropolymer coating layer may have a proper degree of crystallinity, the interdiffusion with the primer layer may be effectively carried out, and the multi-layered film may have excellent physical properties such as durability and weather resistance.

Unless specifically defined otherwise in this specification, the unit "part(s) by weight" refers to a weight ratio between components.

The fluoropolymer coating layer according to one exemplary embodiment of the present application may further include a pigment or filler to control the color or opacity of the fluoropolymer coating layer or for other purposes, as well as the above-described components. In this case, examples of the pigment or filler that may be used herein may include a metal oxide such as titanium dioxide (TiO₂), silica or alumina, a black pigment such as calcium carbonate, barium sulfate or carbon black, or a pigment component showing different colors, but the present application is not limited thereto. The pigment or filler as described above may also serve to further improve interfacial adhesive strength upon the interdiffusion between the fluoropolymer coating layer and the primer layer due to the presence of an innate functional group included in each component, along with the innate effect of controlling the color or opacity of the fluoropolymer coating layer. The pigment may be present at content of 60 wt% or less, based on a solid content of the fluoropolymer coating layer, but the present application is not limited thereto.

Also, the fluoropolymer coating layer according to one exemplary embodiment of the present application may further include a conventional component such as a UV stabilizer, a thermal stabilizer, a dispersing agent, or barrier particles.

According to one exemplary embodiment of the present application, the fluoropolymer coating layer including such a component may have a thickness of approximately 3 to 50 µm, or 10 to 30 µm, but the thickness of the fluoropolymer coating layer may be changed according to a purpose.

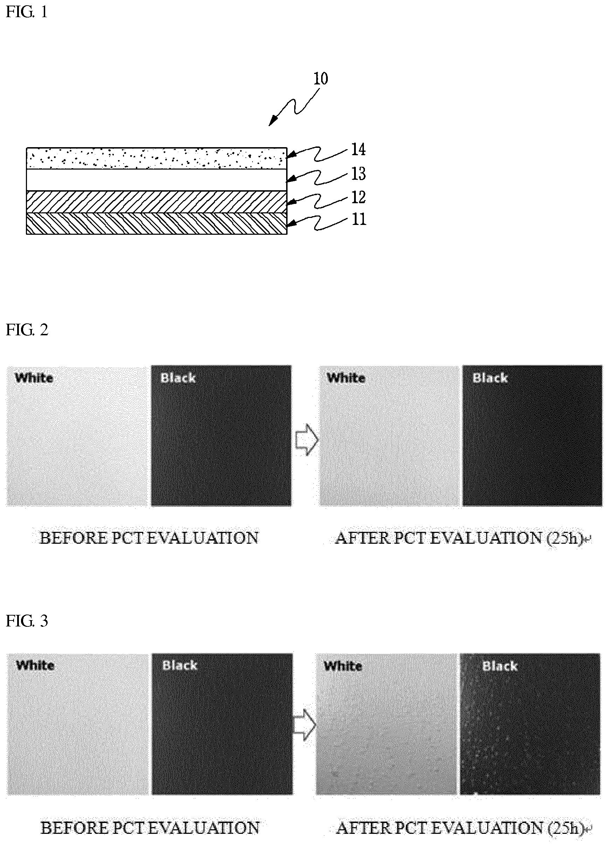

FIG. 1 is a schematic diagram showing a multi-layered film according to one exemplary embodiment of the present application. That is, as shown in FIG. 1, a multi-layered film 10 according to one exemplary embodiment of the present application may include a substrate 11, a barrier film 12 formed on one surface of the substrate, a primer layer 13 formed on the barrier film 12, and a fluoropolymer coating layer 14 formed on the primer layer 13.

Although not shown, the multi-layered film may also include primer layers formed on both surfaces of a substrate or a barrier film, and fluoropolymer coating layers formed on the respective primer layers.

Also, the multi-layered film according to one exemplary embodiment of the present application may further include various functional layers known in the related art, as necessary. Examples of the functional layers may include an adhesive layer or an insulation layer. For example, in the multi-layered film according to one exemplary embodiment of the present application, the above-described primer layer and fluoropolymer coating layer may be formed on one surface of the substrate, and the adhesive layer and the insulation layer may be sequentially formed on the other surface of the substrate. The adhesive layer or the insulation layer may be formed using various methods known in the related art. For example, the insulation layer may be a layer of ethylenevinylacetate (EVA) or linear low-density polyethylene (LDPE). The layer of ethylenevinylacetate (EVA) or linear low-density polyethylene (LDPE) may function as an insulation layer, and also function to enhance adhesive strength to an encapsulant, save on the manufacturing cost and maintain excellent reworkability as well.

Also, the present application is directed to providing a method of preparing a multi-layered film.

By way of example, the method of preparing a multi-layered film includes:
forming a primer layer by coating an upper portion of a barrier film with a primer coating solution including a copolymer having compatibility with a fluoropolymer; and
coating an upper portion of the primer layer with a composition for coating a fluoropolymer.

The method of preparing a multi-layered film according to one exemplary embodiment of the present application is characterized by forming all of the primer layer and the fluoropolymer layer on the barrier film by coating. In this case, a coating method is not particularly limited, and any of methods including offsetting, gravure coating, roll coating and knife-edge coating may be used without limitation as long as they can be used to form a coating layer.

In the case of the primer layer, for example, an upper portion of the barrier film is coated with a primer coating solution including a copolymer having compatibility with the fluoropolymer, and the primer layer may be formed by drying the primer coating solution under predetermined conditions.

To provide the barrier film with the multi-layered film including a fluoropolymer coating having an excellent adhesive strength without using an additional adhesive or adhesive layer, the primer may be a modified copolymer containing a functional group formed by copolymerization with the silane coupling agent, the titanium-based coupling agent, the zirconium-based coupling agent or the aluminum-based coupling agent as described above, and the coating solution may be prepared by dissolving or dispersing the modified copolymer in a suitable organic solvent. As the organic solvent, methylethylketone, ethanol, isopropanol, toluene, ethylacetate, butylacetate, cyclohexanonol, or a mixture thereof may be used alone or in combination.

The coating solution may also further include other various additives, for example, an antioxidant, an anti-rusting agent, and a curing agent as necessary.

Also, the specific kind of barrier films that may be used in the present application is as described above, and subjecting the barrier film to proper deposition treatment, plasma treatment, corona treatment, treatment with a primer, an anchoring agent or a coupling agent, or thermal treatment may be further performed.

According to the present application, the primer layer is first formed using the method as described above, and the fluoropolymer coating layer is then formed using a coating method. In the present application, the coating solution forming the fluoropolymer coating layer may be prepared by dissolving or dispersing each component forming the above-described fluoropolymer coating layer in a solvent having a relatively low boiling point, particularly a solvent having a boiling point of 200 °C or less. According to one exemplary embodiment of the present application, when the fluoropolymer has an amorphous region, or is mixed with an amorphous resin, the components forming the fluoropolymer coating layer may be effectively dissolved in a solvent having a relatively low boiling point. Therefore, in the present application, the manufacturing cost may be saved since a high-temperature drying process is not required during a manufacturing procedure, and qualities of a product may also be improved since thermal deformation or thermal shock of the substrate caused during the high-temperature drying process is prevented.

Examples of the above-described solvent that may be used in the present application may include, but are not limited to, acetone, methylethylketone (MEK), dimethylformamide (DMF), or dimethylacetamide (BMAC), which may be used alone or in combination.

Also, the composition for coating a fluoropolymer may be an aqueous dispersion coating composition. For example, only an aqueous dispersion including a fluoropolymer dispersed in water may be coated. In this case, a dispersing agent is included in the aqueous dispersion.

According to one exemplary embodiment of the present application, the coating solution applicable to formation of the fluoropolymer coating layer may further include various additives such as a pigment, a filler, a UV stabilizer, a dispersing agent or a thermal stabilizer in addition to the fluoropolymer. Each of the additives may be dissolved in a solvent together with the fluoropolymer, or may be prepared in the form of a mill base separately from the components, and then mixed with a solvent including the fluoropolymer.

According to one exemplary embodiment of the present application, the method of preparing a coating solution, or the respective components included in the coating solution are not particularly limited, and various methods known in the related art may be properly employed.

In the present application, a coating method using the coating solution is not particularly limited. For example, the coating method may be performed according to the above-described coating method for forming a primer layer. In particular, the solvent in the coating solution may serve to swell a surface of the primer layer during a coating procedure so as to facilitate an interdiffusion action between the primer layer and the fluoropolymer coating layer.

According to one exemplary embodiment of the present application, after coating of each layer, an operation of drying each layer may be further performed. The drying conditions are not particularly limited, but the drying may be, for example, performed at room temperature to 200 °C or less, preferably a temperature of approximately 25 °C to 180 °C for approximately 30 seconds to 30 minutes, preferably approximately 1 to 10 minutes. When the drying conditions are controlled within these ranges, an increase in the manufacturing cost may be prevented, and degradation of product qualities caused by thermal deformation or thermal shock may also be prevented. Also, a degree of interdiffusion of materials between the primer layer and the fluoropolymer coating layer may be adjusted according to the drying conditions. For example, an interdiffusion effect may be enhanced with an increase in drying temperature or drying time of the fluoropolymer. According to one exemplary embodiment of the present application, the primer layer may be dried at a temperature of approximately 100 to 120 °C for approximately several seconds to 1 minute, and the fluoropolymer coating layer may be dried at a temperature of approximately 160 to 200 °C for approximately 1 to 2 minutes.

In addition, the present application is directed to providing a subsidiary material for preparing a photovoltaic module including the multi-layered film, and a photovoltaic module including the subsidiary material for preparing a photovoltaic module.

A structure of the photovoltaic module according to one exemplary embodiment of the present application is not particularly limited as long as the multi-layered film can be included as the subsidiary material for preparing a photovoltaic module. For example, the photovoltaic module may have various structures known in the related art. By way of example, the multi-layered film may be used as a backsheet for photovoltaic cells. In this case, the barrier film is disposed toward a photovoltaic cell, and thus the fluoropolymer coating layer becomes a surface layer.

In general, the photovoltaic module may include a transparent front substrate, a backsheet, and a photovoltaic cell encapsulated between the front substrate and the backsheet by an encapsulant, or a photovoltaic cell array disposed in series or parallel.

As such, representative examples of the active layer constituting the photovoltaic cell or photovoltaic cell array may include a crystalline or amorphous silicon wafer, or a compound semiconductor such as CIGS or CTS.

Since the multi-layered film of the present application may include a module including the above-described active layer, the multi-layered film is applicable to various photovoltaic modules known in the related art without limitation. In this case, a method of constituting the module, or the kind of other materials is not particularly limited.

Hereinafter, the present application will be described in further detail with reference to Examples according to the present application and Comparative Examples not according to the present application. However, the scope of the present application is not limited to the following Examples

Physical properties of each of the films prepared in Examples and Comparative Examples were measured using the following methods.

### 1. 180° peel strength

Peel strength was measured based on the ASTM D1897 standard by cutting a test sample into pieces with a width of 10 mm and peeling the test sample at a peel rate of 4.2 mm/sec and a peel angle of 180°.

### 2. Cross-hatch adhesive strength

A cross cut test was performed based on a crosscut test standard ASTM D3002/D3359. More specifically, 11 lines were drawn in each of longitudinal and vertical directions at intervals of 1 mm on a test sample using a knife to prepare 100 square lattices each having a width and length of 1 mm. Thereafter, when a CT-24 adhesive tape commercially available from Nichiban Ltd. was attached to the cut surface of the test sample and detached from the cut surface, the state of the surface of the test sample that was peeled off together with the tape was measured based on the following criteria.

### <Evaluation criteria of cross-hatch adhesive strength>

5B: There is no peeled surface.
4B: A peeled surface accounts for less than 5% of the entire surface.
3B: A peeled surface accounts for 5 to 15% of the entire surface.
2B: A peeled surface accounts for 15 to 35% of the entire surface.
1B: A peeled surface accounts for 35 and 65% of the entire surface.
**0**B: The surface is almost entirely peeled off.

### 3. Pressure cooker test (PCT)

The multi-layered films prepared in Examples and Comparative Examples were kept for 25 hours or 50 hours in an oven which was maintained under the conditions of 2 atmospheric pressures, a temperature of 121 °C and a relative humidity (R.H.) of 100%, and changes in adhesive strength of the multi-layered films were then measured.

### 4. Measurement of film deformation

The multi-layered films prepared in Example 1 and Comparative Example 2 were kept for 25 hours in an oven which was maintained under the conditions of 2 atmospheric pressures, 121 °C and 100% R.H., and deformation of the multi-layered films was observed. The observation results are shown in FIGS. 2 and 3.

### Preparative Examples 1 to 6 : Preparation of primer

300 g of toluene was put into a reactor, and a temperature in the reactor was maintained at 80 °C. In this case, an inner part of the reactor was filled with nitrogen gas to inhibit an oxidation reaction caused by ambient air, and a reaction product was continuously stirred in a stirrer to facilitate the reaction. The temperature condition was set to 80 °C, and each acrylic monomer prepared as listed in the following Table 1 was injected into the reactor. After injection of the acrylic monomer was completed, a silane coupling agent, KBM503, was injected. In this case, mixing ratios and injection amounts of the acrylic monomer prepared in each Preparative Example and the silane coupling agent are listed in Table 1.

Subsequently, 1 g of 2,2-azobis(2,4-dimethylvaleronitrile) (V-65) was dissolved as an initiator in 20 g of toluene, and injected into the reaction using a syringe for radical copolymerization. The resulting mixture was stirred at a temperature of 80 °C for 8 hours, and the reaction was stopped to prepare primers MSC1 to MSC6 which were silane-modified acrylic copolymers.

**Table 1**

| | Preparative Examples | | | | | |
|---|---|---|---|---|---|---|
| | 1 | 2 | 3 | 4 | 5 | 6 |
| Silane-modified acrylic copolymer | MSC1 | MSC2 | MSC3 | MSC4 | MSC5 | MSC6 |
| Toluene | 300 g | 300 g | 300 g | 300 g | 300 g | 300 g |
| Acrylic monomer (Content) | MMA (90 g) | MMA (85 g) | MMA (70 g) | MMA (50 g) | MMA (40 g)+EA (30 g) | MMA (50 g)+GMA (20 g)+EA (30 g) |
| Silane coupling agent (KBM503) | 10 g | 15 g | 30 g | 50 g | 30 g | 20 g |
| Initiator (V-65)/toluene | 1 g/20 g | 1 g/20 g | 1 g/20 g | 1 g/20 g | 1 g/20 g | 1 g/20 g |
| Reaction temperature (°C) | 80 | 80 | 80 | 80 | 80 | 80 |
| Reaction time (h) | 8 | 8 | 8 | 8 | 8 | 8 |
| Measured S/C (%) value | 20 wt% | 20 wt% | 20 wt% | 20 wt% | 20 wt% | 20 wt% |
| MMA: methylmethacrylate | | | | | | |
| EA: ethylacrylate | | | | | | |
| GMA: glycidylmethacrylate | | | | | | |
| Measured S/C (%) value: a percentage obtained by measuring a solid content of a primer solution after polymerization | | | | | | |

### Examples 1 to 12

### Preparation of substrate layer

A surface of a PET film (thickness: 250 µm, commercially available from Kolon corp) whose surfaces were treated with an acrylic primer was subjected to corona treatment.

A surface of the PET film was coated with an adhesive, dried at 100 °C for 1 minute, and then attached to aluminum foil (Al foil) having a thickness of 20 µm using a laminator. When the PET film was attached to the Al foil, a roll of the laminator was maintained at a temperature of 60 °C. Thereafter, the adhesive was cured for a sufficient curing time in an aging process in which the adhesive was kept at room temperature for a day, and then kept at a temperature of 40 to 60 °C for 4 days in an oven. A solid content of the adhesive was adjusted so that the adhesive had a thickness after drying of approximately 10 to 13 µm.

### Preparation of coating solution for fluoropolymer coating layer

### Preparation of white fluoropolymer coating solution

A first coating solution was prepared by dissolving 140 g of a copolymer, which included vinylidene fluoride (VDF) and chlorotrifluoroethylene (CTFE) at a weight ratio of 85:15 (VDF:CTFE) and in a polymerized form, and 60 g of a copolymer, which included VDF and hexafluoropropylene (HFP) at a weight ratio of 88:12 (VDF:HFP) and in a polymerized form, in 800 g of N,N-dimethyl formamide (DMF).

As a separate procedure, 4.8 g of a pigment dispersing agent, BYK W9010 (commercially available from BYK), and 240 g of titanium dioxide (TiPure TS6200 commercially available from DuPont) were dissolved in 100 g of DMF, and 100 g of zirconia beads having a diameter of 0.3 mm was also added. Thereafter, the resulting mixture was stirred at a rotary speed of 1,000 rpm for an hour, and zirconia beads were completely removing the beads to prepare a mill base.

The prepared mill base was put into the previously prepared first coating solution, and re-stirred to prepare a white fluoropolymer coating solution. As above, the mill base was prepared at an amount 1.5 times higher than an actual amount of the mill base introduced into the fluoropolymer coating layer in consideration of an amount of the mill base to be lost during removal of the beads.

### Primer coating

A surface of aluminum foil of a PET film to which previously prepared aluminum foil was attached was coated with the silane-modified acrylic copolymer as prepared thus. The coating was performed using a Mayer bar, and a thickness of a primer layer was adjusted by adjusting a number of controlling a thickness of a Mayer bar and controlling a solid content of the silane-modified acrylic copolymer to 20% by weight. After the coating was completed, the silane-modified acrylic copolymer coating layer was dried at approximately 120 °C for approximately 30 seconds to form a primer layer having a thickness of 1 to 3 µm.

### Formation of fluoropolymer coating layer

An upper portion of aluminum foil on which the silane-modified acrylic copolymer was coated as a primer was coated with the white fluoropolymer coating solution previously prepared thus, using an applicator, by controlling a solid content in the fluoropolymer coating solution so that a coating layer had a thickness after drying of approximately 15 to 30 µm. Thereafter, the white fluoropolymer coating solution was dried at 180 °C for approximately 2 minutes to form a fluoropolymer coating layer.

In Examples 1 to 6, each multi-layered film was formed on a primer layer, which was coated with each of the primers prepared in Preparative Examples 1 to 6, using the white fluoropolymer coating solution.

### Comparative Example 1

A fluoropolymer coating layer was directly formed on aluminum foil without forming a primer layer to prepare a multi-layered film. In this case, a method of forming a fluoropolymer on aluminum foil was performed in the same manner as in Example 1.

### Comparative Example 2

A multi-layered film was prepared in the same manner as in Example 1, except that only an uncopolymerized silane coupling agent, KBM 503, was used as a primer instead of the silane-modified acrylic copolymer used as the primer in Example 1.

### Comparative Example 3

A multi-layered film was prepared in the same manner as in Example 1, except that only an uncopolymerized acrylic monomer, MMA, was used as a primer instead of the silane-modified acrylic copolymer used as the primer in Example 1.

### Comparative Example 4

A multi-layered film was prepared in the same manner as in Example 1, except that an epoxy primer layer was formed on an aluminum foil instead of forming a primer layer composed of the silane-modified acrylic copolymer on the aluminum foil.

### Experimental Example 1

180° peel strength and cross-hatch tests were performed on each of the multi-layered films prepared in Examples 1 to 6 and Comparative Examples 1 to 6 before and after a pressure cooker test (PCT). More particularly, each of the multi-layered films was kept under the conditions of 2 atmospheric pressures, 121 °C and 100% R.H. for 25 hours or 50 hours, and the 180° peel strength and cross-hatch tests were then performed on the multi-layered films to determine a change in peel strength. The evaluation results are listed in the following Table 2.

**Table 2**

| | Primer | 180° peel strength (kg/cm) | | | Cross-hatch test results | | |
|---|---|---|---|---|---|---|---|
| | | Initial | 25 hrs | 50 hrs | Initial | 25 hrs | 50 hrs |
| Example 1 | MSC1 | T | T | T | 5B | 5B | 5B |
| Example 2 | MSC2 | T | T | T | 5B | 5B | 5B |
| Example 3 | MSC3 | T | T | T | 5B | 5B | 5B |
| Example 4 | MSC4 | T | T | T | 5B | 5B | 5B |
| Example 5 | MSC5 | T | T | T | 5B | 5B | 5B |
| Example 6 | MSC6 | T | T | T | 5B | 5B | 5B |
| Comparative Example 1 | - | 0.011 | 0 | 0 | 0B | 0B | 0B |
| Comparative Example 2 | KBM503 | 0.048 | 0 | 0 | 0B | 0B | 0B |
| Comparative Example 3 | MMA | 0.023 | 0 | 0 | 0B | 0B | 0B |
| Comparative Example 4 | epoxy | 0.002 | 0 | 0 | 0B | 0B | 0B |
| T: Accurate peel strength could not be measured because the film was torn while being peeled. | | | | | | | |

As listed in Table 2, it could be seen that the multi-layered films including the primer layer of the silane-modified acrylic copolymer according to the exemplary embodiments of the present application exhibited a good adhesive strength, and also had excellent adhesive strength even after the PCT was performed for 50 hours. Meanwhile, it was confirmed that the multi-layered films of Comparative Examples, which had no primer layer or included a silane monomer, an acrylic monomer or an epoxy primer layer, exhibited a greatly decreased adhesive strength.

As shown in FIG. 2, it was also confirmed that film deformation did not take place even when the PCT was performed for 25 hours in the case of Example 1. As shown in FIG. 3, however, it was confirmed that bubbles were formed after the PCT in the case of Comparative Example 2 in which only a silane coupling agent was used.

### Examples 7 to 12

Multi-layered films were prepared in the same manner as in Examples 1 to 6, except that a separately prepared black fluoropolymer coating solution was used as the fluoropolymer coating solution instead of each of the white fluoropolymer coating solutions used in Examples 1 to 6.

### Preparation of black fluoropolymer coating solution

The first coating solution was the same solution as used in the white fluoropolymer coating solution. As a separate procedure, 0.8 g of a pigment dispersing agent, BYK 9076 (commercially available from BYK), and 8 g of carbon black (MA100 commercially available from Mitsubishi) were dissolved in 100 g of DMF, and 100 g of zirconia beads having a diameter of 0.3 mm was also added. Thereafter, the resulting mixture was stirred at a rotary speed of 1,000 rpm for an hour, and the zirconia beads were completely removed to prepare a mill base.

The prepared mill base and 60 g of talc (commercially available from Nippon Talc) was put into the previously prepared first coating solution, and stirred again to prepare a black fluoropolymer coating solution. As described above, the mill base was prepared at an amount 1.5 times higher than an actual amount of the mill base introduced into the fluoropolymer coating layer in consideration of an amount of the mill base to be lost during removal of the beads.

### Comparative Examples 4 to 6

Multi-layered films were prepared in the same manner as in Comparative Examples 1 to 3, except that the black fluoropolymer coating solution used in Examples 7 to 12 was used as the fluoropolymer coating solution instead of the white fluoropolymer coating solution used in Comparative Examples 1 to 3.

### Experimental Example 2

180° peel strength and cross-hatch tests were performed on each of the multi-layered films prepared in Examples 7 to 12 and Comparative Examples 4 and 6 before and after a pressure cooker test (PCT). More particularly, each of the multi-layered films was kept under the conditions of 2 atmospheric pressures, 121 °C and 100% R.H. for 25 hours or 50 hours, and the 180° peel strength and cross-hatch tests were then performed on the multi-layered films to determine a change in peel strength. The evaluation results are listed in the following Table 3.

**Table 3**

| | Primer | 180° peel strength (kg/cm) | | | Cross-hatch test results | | |
|---|---|---|---|---|---|---|---|
| | | Initial | 25 hrs | 50 hrs | Initial | 25 hrs | 50 hrs |
| Example 7 | MSC1 | T | T | T | 5B | 5B | 5B |
| Example 8 | MSC2 | T | T | T | 5B | 5B | 5B |
| Example 9 | MSC3 | T | T | T | 5B | 5B | 5B |
| Example 10 | MSC4 | T | T | T | 5B | 5B | 5B |
| Example 11 | MSC5 | T | T | T | 5B | 5B | 5B |
| Example 12 | MSC6 | T | T | T | 5B | 5B | 5B |
| Comparative Example 4 | - | 0.002 | 0 | 0 | 0B | 0B | 0B |
| Comparative Example 5 | KBM503 | 0.021 | 0 | 0 | 0B | 0B | 0B |
| Comparative Example 6 | MMA | 0.008 | 0 | 0 | 0B | 0B | 0B |
| T: Accurate peel strength could not be measured because a resin layer was torn while being peeled. | | | | | | | |

As listed in Table 3, it could be seen that the multi-layered films including the primer layer of the silane-modified acrylic copolymer according to the exemplary embodiments of the present application exhibited a good adhesive strength regardless of the fluoropolymer coating solution, and also had excellent adhesive strength even after the PCT was performed for 50 hours. Meanwhile, it was confirmed that the multi-layered films of Comparative Examples, which had no primer layer or included a primer layer of a silane monomer or an acrylic monomer, exhibited a greatly decreased adhesive strength.

That is, it could be seen that, when the silane-modified acrylic copolymer was used as the primer in Examples 1 to 12, Comparative Examples 1 to 6 and Experimental Examples, the fluoropolymer coating layer exhibited excellent interfacial adhesive strength to the aluminum foil, and also had better durability. This was considered to be due to the fact that the silane-modified acrylic copolymer of the primer layer formed a chemical bond with a surface of the aluminum foil, and an adhesive strength was improved due to interdiffusion of materials into the fluoropolymer coating layer, thereby achieving adhesive strength and durability as well.

## Claims

1. A multi-layered film comprising:
a barrier film;
a primer layer formed on the barrier film; and
a fluoropolymer coating layer formed on the primer layer,
wherein the primer layer includes a copolymer having compatibility with a fluoropolymer, and the copolymer having compatibility with the fluoropolymer includes a functional group formed by copolymerization with a silane coupling agent, a titanium-based coupling agent, a zirconium-based coupling agent, or an aluminum-based coupling agent,
wherein the copolymer of the primer layer is a copolymer of polymerizable monomer having compatibility with the fluoropolymer; and a silane coupling agent, a titanium-based coupling agent, a zirconium-based coupling agent, or an aluminum-based coupling agent,
wherein a mixing ratio of the polymerizable monomer and the coupling agent is 40:60 to 90:10, based on the weight,
wherein the primer layer is a coating layer of the copolymer having compatibility with the fluoropolymer, and
wherein a Si-O, Ti-O, Zr-O or Al-O bond is formed at an interface of the barrier film and the primer layer.

2. The multi-layered film of claim 1, wherein the barrier film is a metal thin film, or an inorganic deposition film.

3. The multi-layered film of claim 1, wherein a hydrogen bond is formed at the interface of the barrier film and the primer layer.

4. The multi-layered film of claim 1, wherein the copolymer of the primer layer includes a main chain backbone having compatibility with the fluoropolymer, and a functional group formed by copolymerizing a silane coupling agent, a titanium-based coupling agent, a zirconium-based coupling agent, or an aluminum-based coupling agent into the main chain backbone.

5. The multi-layered film of claim 4, wherein the main chain backbone is at least one selected from the group consisting of a (meth)acrylic main chain backbone, a (meth)acrylamide-based main chain backbone, and a main chain backbone of a free radical addition polymer derived from a monomer mixture including a (meth)acrylic monomer, a (meth)acrylamide-based monomer or a vinyl-based monomer as a main component.

6. The multi-layered film of claim 1, wherein the polymerizable monomer is at least one selected from the group consisting of a (meth)acrylic monomer, a (meth)acrylamide-based monomer, and a vinyl-based monomer.

7. The multi-layered film of claim 1, wherein the copolymer of the primer layer includes a silane-modified acrylic copolymer.

8. The multi-layered film of claim 1, further comprising a substrate formed under the barrier film.

9. A method of preparing a multi-layered film, comprising:
forming a primer layer by coating an upper portion of a barrier film with a primer coating solution including a copolymer having compatibility with a fluoropolymer; and
coating an upper portion of the primer layer with a composition for coating a fluoropolymer,
wherein the copolymer having compatibility with the fluoropolymer of the primer coating solution includes a functional group formed by copolymerization with a silane coupling agent, a titanium-based coupling agent, a zirconium-based coupling agent, or an aluminum-based coupling agent,
wherein the copolymer of the primer coating solution is a copolymer of polymerizable monomer having compatibility with the fluoropolymer; and a silane coupling agent, a titanium-based coupling agent, a zirconium-based coupling agent, or an aluminum-based coupling agent,
wherein a mixing ratio of the polymerizable monomer and the coupling agent is 40:60 to 90:10, based on the weight, and
wherein a Si-O, Ti-O, Zr-O or Al-O bond is formed at an interface of the barrier film and the primer layer.

10. The method of claim 9, wherein the composition for coating a fluoropolymer includes a fluoropolymer and a solvent having a boiling point of 200 °C or less.

11. A photovoltaic module comprising a subsidiary material for preparing a photovoltaic module including the multi-layered film of claim 1.

## Patentansprüche

1. Mehrschichtiger Film, der umfasst:
einen Barrierefilm;
eine Primerschicht, die auf dem Barrierefilm gebildet ist; und
eine Fluorpolymer-Beschichtungsschicht, die auf der Primerschicht gebildet ist,
wobei die Primerschicht ein Copolymer umfasst, mit einer Kompatibilität mit einem Fluorpolymer, und das Copolymer mit einer Kompatibilität mit dem Fluorpolymer eine funktionelle Gruppe umfasst, die durch Copolymerisieren mit einem Silankopplungsmittel, einem Titan-basierten Kopplungsmittel, einem Zirkonium-basierten Kopplungsmittel oder einem Aluminium-basierten Kopplungsmittel gebildet ist,
wobei das Copolymer der Primerschicht ein Copolymer eines polymerisierbaren Monomers mit einer Kompatibilität mit dem Fluorpolymer; und eines Silankopplungsmittels, eines Titan-basierten Kopplungsmittels, eines Zirkonium-basierten Kopplungsmittels oder eines Aluminium-basierten Kopplungsmittels ist,
wobei ein Mischverhältnis des polymerisierbaren Monomers und des Kopplungsmittels 40 : 60 bis 90 : 10 ist, bezogen auf das Gewicht,
wobei die Primerschicht eine Beschichtungsschicht des Copolymers mit einer Kompatibilität mit dem Fluorpolymer ist, und
wobei eine Si-O-, Ti-O-, Zr-O- oder Al-O-Bindung an der Zwischenfläche des Barrierefilms und der Primerschicht gebildet ist.

2. Mehrschichtiger Film nach Anspruch 1, wobei der Barrierefilm ein metallischer Dünnfilm oder ein anorganischer Abscheidungsfilm ist.

3. Mehrschichtiger Film nach Anspruch 1, wobei eine Wasserstoffbindung an der Grenzfläche des Barrierefilms und der Primerschicht gebildet ist.

4. Mehrschichtiger Film nach Anspruch 1, wobei das Copolymer der Primerschicht ein Hauptkettengerüst mit Kompatibilität mit dem Fluorpolymer und eine funktionelle Gruppe hat, die durch Copolymerisieren eines Silankopplungsmittels, eines Titan-basierten Kopplungsmittels, eines Zirkonium-basierten Kopplungsmittels in das Hauptkettengerüst gebildet wird.

5. Mehrschichtiger Film nach Anspruch 1, wobei das Hauptkettengerüst eines ist, ausgewählt aus der Gruppe, bestehend aus einem (meth)acrylischen Hauptkettengerüst, einem (Meth)acrylamid-basierten Hauptkettengerüst, einem Hauptkettengerüst eines freien radikalischen Additionspolymers, erhalten aus einem Monomergemisch, umfassend ein (Meth)acrylmonomer, ein (Meth)acrylamid-basiertes Monomer oder ein Vinyl-basiertes Monomer als ein Hauptbestandteil.

6. Mehrschichtiger Film nach Anspruch 1, wobei das polymerisierbare Monomer zumindest eines ist, ausgewählt aus der Gruppe, bestehend aus einem (meth)acrylischen Monomer, einem (Meth)acrylamid-basierten Monomer und einem Vinyl-basierten Monomer.

7. Mehrschichtiger Film nach Anspruch 1, wobei das Copolymer der Primerschicht ein Silan-modifiziertes acrylisches Copolymer einschließt.

8. Mehrschichtiger Film nach Anspruch 1, ferner umfassend einen Träger, der unter dem Barrierefilm gebildet ist.

9. Verfahren zum Herstellen eines mehrschichtigen Films, umfassend:
Bilden einer Primerschicht durch Beschichten eines oberen Teils eines Barrierefilms mit einer Primerbeschichtungslösung, die ein Copolymer mit einer Kompatibiltät mit einem Fluorpolymer hat; und
Beschichten eines oberen Teils der Primerschicht mit einer Zusammensetzung zum Beschichten eines Fluorpolymers,
wobei das Copolymer mit einer Kompatibilität mit dem Fluorpolymer der Primerbeschichtungslösung eine funktionelle Gruppe umfasst, gebildet durch Copolymerisieren mit einem Silankopplungsmittel, einem Titan-basierten Kopplungsmittel, einem Zirkonium-basierten Kopplungsmittel oder einem Aluminium-basierten Kopplungsmittel,
wobei das Copolymer der Primerbeschichtungslösung ein Copolymer eines polymerisierbaren Monomers mit Kompatibilität mit dem Fluorpolymer; und eines Silankopplungsmittels, eines Titan-basierten Kopplungsmittels, eines Zirkonium-basierten Kopplungsmittels oder eines Aluminium-basierten Kopplungsmittels ist,
wobei ein Mischungsverhältnis des polymerisierbaren Monomers und des Kopplungsmittels 40 : 60 zu 90 : 10, bezogen auf das Gewicht, ist, und
wobei eine Si-O-, Ti-O-, Zr-O- oder Al-O-Bindung an der Zwischenfläche des Barrierefilms und der Primerschicht gebildet ist.

10. Verfahren nach Anspruch 9, wobei die Zusammensetzung zum Beschichten eines Fluorpolymers ein Fluorpolymer und ein Lösungsmittel mit einem Siedepunkt von 200°C oder weniger einschließt.

11. Photovoltaikmodul, umfassend ein Zusatzmaterial zum Herstellen eines Photovoltaikmoduls, das den mehrschichtigen Film nach Anspruch 1 einschließt.

## Revendications

1. Film multicouches comprenant :
un film barrière ;
une couche de primaire formée sur le film barrière ; et
une couche d'un revêtement fluoropolymère formée sur la couche de primaire,
où la couche de primaire inclut un copolymère ayant une compatibilité avec un fluoropolymère, le copolymère ayant une compatibilité avec le fluoropolymère incluant un groupement fonctionnel formé par copolymérisation avec un agent de couplage silané, un agent de couplage à base de titane, un agent de couplage à base de zirconium ou un agent de couplage à base d'aluminum,
où le copolymère de la couche de primaire est un copolymère d'un monomère polymérisable ayant une compatibilité avec le fluoropolymère ; et un agent de couplage silané, un agent de couplage à base de titane, un agent de couplage à base de zirconium ou un agent de couplage à base d'aluminum,
où un rapport de mélange en poids entre le monomère polymérisable et l'agent de couplage va de 40:60 à 90:10,
où la couche de primaire est d'une couche de revêtement du copolymère ayant une compatibilité avec le fluoropolymère et
où une liaison Si-O, Ti-O, Zr-O ou Al-O est formée à une interface entre le film barrière et la couche de primaire.

2. Film multicouches de la revendication 1, où le film barrière est un film métallique fin ou un film inorganique obtenu par dépôt.

3. Film multicouches de la revendication 1, où une liaison hydrogène est formée à l'interface entre le film barrière et la couche de primaire

4. Film multicouches de la revendication 1, où le copolymère de la couche de primaire inclut un squelette ayant une chaîne principale qui a une compatibilité avec le fluoropolymère et un groupement fonctionnel formé par copolymérisation avec un agent de couplage silané, un agent de couplage à base de titane, un agent de couplage à base de zirconium ou un agent de couplage à base d'aluminum dans le squelette ayant une chaîne principale.

5. Film multicouches de la revendication 4, où le squelette ayant une chaîne principale est un au moins sélectionné dans le groupe consistant en un squelette ayant une chaîne principale (méth)acrylique, un squelette ayant une chaîne principale à base d'un (méth)acrylamide et un squelette ayant une chaîne principale d'un polymère d'addition obtenu par polymérisation radicalaire à partir d'un mélange de monomères incluant un monomère (méth)acrylique, un monomère à base d'un (méth)acrylamide ou un monomère à base de vinyle comme composant principal.

6. Film multicouches de la revendication 1, où le monomère polymérisable est un au moins sélectionné dans le groupe consistant en un monomère (méth)acrylique, un monomère à base d'un (méth)acrylamide ou un monomère à base de vinyle.

7. Film multicouches de la revendication 1, où le copolymère de la couche de primaire inclut un copolymère acrylique modifié par un silane.

8. Film multicouches de la revendication 1 comprenant en outre un substrat formé sous le film barrière.

9. Procédé de préparation d'un film multicouches, comprenant :
la formation d'une couche de primaire par revêtement d'une partie supérieure d'un film barrière avec une solution d'un primaire de revêtement incluant un copolymère ayant une compatibilité avec un fluoropolymère ; et
le revêtement d'une partie supérieure de la couche de primaire avec une composition pour revêtement d'un fluoropolymère,
où le copolymère ayant une compatibilité avec un fluoropolymère de la solution de primaire de revêtement inclut un groupement fonctionnel formé par copolymérisation avec un agent de couplage silané, un agent de couplage à base de titane, un agent de couplage à base de zirconium ou un agent de couplage à base d'aluminum,
où le copolymère de la solution de primaire de revêtement est un copolymère d'un monomère polymérisable ayant une compatibilité avec le fluoropolymère ; et un agent de couplage silané, un agent de couplage à base de titane, un agent de couplage à base de zirconium ou un agent de couplage à base d'aluminum,
où un rapport de mélange en poids entre le monomère polymérisable et l'agent de couplage va de 40:60 à 90:10 et
où une liaison Si-O, Ti-O, Zr-O ou Al-O est formée à une interface entre le film barrière et la couche de primaire.

10. Procédé de la revendication 9, où la composition pour revêtement d'un fluoropolymère inclut un fluoropolymère et un solvant ayant un point d'ébullition inférieur ou égal à 200 °C.

11. Module photovoltaïque comprenant un matériau auxilaire pour la préparation d'un module photovoltaïque incluant le film multicouches de la revendication 1.
